# EUROPEAN PATENT APPLICATION

(11) **EP 2 056 097 A2**
(43) Date of publication of application: **06.05.2009**
(21) Application number: 08166888.1
(22) Date of filing: 17.10.2008
(51) Int. Cl.: G01N 21/956

(54) **Producing method of wired circuit board**

(30) Priority: 01.11.2007 JP 2007285448
(71) Applicant: Nitto Denko Corporation, Ibaraki-shi, Osaka 567-8680 (JP)
(72) Inventor: Toyoda, Yoshihiro c/o Nitto Denko Corporation, Osaka 567-8680 (JP)
(74) Representative: Schwabe - Sandmair - Marx

(57) **Abstract**

A producing method of a wired circuit board includes the steps of preparing an insulating base layer, forming a wire on the insulating base layer, forming an insulating cover layer on the insulating base layer so as to cover the wire, and applying near-infrared light with a wavelength of more than 700 nm and less than 950 nm from either one of the insulating base layer and the insulating cover layer through the other insulating layer to thereby inspect a foreign substance with the light transmitted therethrough.

## Description

### BACKGROUND OF THE INVENTION

### Field of the Invention

The present invention relates to a producing method of a wired circuit board and, more particularly, to a producing method of a wired circuit board such as a COF board, or a flexible wired circuit board.

### Description of the Related Art

A wired circuit board such as a COF board, or a flexible wired circuit board includes an insulating base layer, wires formed thereon, and an insulating cover layer covering the wires. In a producing method of such a wired circuit board, when a metal foreign substance or the like is mixed in an insulating cover layer, a short circuit occurs between the wires so that it is necessary to inspect the presence or absence of such a metal foreign substance.

For example, an inspection method has been proposed wherein infrared light in a wavelength range of 2.8 to 3.4 µm or 3.5 to 4.6 µm is applied to a printed board in which a conductive pattern, a resist print, and a silk-screen print are laminated on a base material (see, e.g., the specification of International Publication No. WO2004/023122). In the inspection method, a foreign substance is inspected with the light transmitted through the base material, and then further transmitted through the resist print and the silk-screen print each located around the foreign substance, while being absorbed in the foreign substance.

### SUMMARY OF THE INVENTION

However, in the inspection method proposed in International Publication No. WO2004/02312 the printed board is excessively heated by the infrared light in the wavelength range mentioned above. As a result, deformation such as undulation or warping is particularly likely to occur in a printed board formed flexible and thin.

In addition, when there is an organic contaminant resulting from an apparatus for producing a wired circuit board, or from a base material, the infrared light in the foregoing wavelength range according to the specification of International Publication No. WO2004/023122 may be absorbed by the organic contaminant in the same manner as absorbed by the metal foreign substance. Accordingly, there is the possibility of erroneously sensing the organic contaminant as the metal foreign substance, and determining the printed board as a defective product in the inspection to induce a reduction in production efficiency.

Further, in the inspection method proposed in the specification of International Publication No. WO2004/023122, an LED cannot be used as a light source of the infrared light. This leads to the problems of poor directivity of the infrared light, an unstable amount of the light, a shorter lifespan of the light source, and the like.

It is therefore an object of the present invention to provide a producing method of a wired circuit board which allows accurate inspection of a foreign substance as well as the prevention of excessive heating of the wired circuit board.

A producing method of a wired circuit board of the present invention includes the steps of preparing an insulating base layer, forming a wire on the insulating base layer, forming an insulating cover layer on the insulating base layer so as to cover the wire, and applying near-infrared light with a wavelength of more than 700 nm and less than 950 nm from either one of the insulating base layer and the insulating cover layer through the other insulating layer to thereby inspect a foreign substance with the light transmitted therethrough.

In the producing method of a wired circuit board of the present invention, it is preferable that the wavelength of the near-infrared light is more than 750 nm and less than 900 nm.

In the producing method of a wired circuit board of the present invention, it is preferable that the foreign substance is made of at least one metal material selected from the group consisting of copper, tin, and stainless steel.

In accordance with the producing method of a wired circuit board of the present invention, light with a wavelength of more than 700 nm and less than 950 nm is applied from the insulating base layer through the insulating cover layer to thereby inspect a foreign substance with the light transmitted therethrough. That is, when a foreign substance is present, the presence thereof can be accurately inspected with the light transmitted through the insulating base layer and the insulating cover layer which are located around the foreign substance. On the other hand, when a foreign substance is not present, the absence thereof can be accurately inspected with the light transmitted through the insulating base layer and the insulating cover layer.

Alternatively, light with a wavelength of more than 700 nm and less than 950 nm is applied from the insulating cover layer through the insulating base layer to thereby inspect a foreign substance with the light transmitted therethrough. That is, when a foreign substance is present, the presence thereof can be accurately inspected with the light transmitted through the insulating cover layer and the insulating base layer which are located around the foreign substance. On the other hand, when a foreign substance is not present, the absence thereof can be accurately inspected with the light transmitted through the insulating cover layer and the insulating base layer.

In particular, since the wavelength of the light is more than 700 nm and less than 950 nm, even when there is an organic contaminant in addition to the foreign substance, only the foreign substance can be sensed without sensing the organic contaminant. As a result, it is possible to prevent a reduction in the production efficiency of a wired circuit board.

At the same time, since the wavelength of the light is more than 700 nm and less than 950 nm in the inspection, excessive heating of the wired circuit board can be prevented. Therefore, it is possible to effectively prevent the deformation of the wired circuit board.

### BRIEF DESCRIPTION OF THE DRAWINGS

FIG. 1 is a cross-sectional view along a widthwise direction of an embodiment of a wired circuit board produced by a producing method of a wired circuit board of the present invention;
FIG. 2 is a process view according to an embodiment of the producing method of a wired circuit board of the present invention,
   (a) showing the step of preparing an insulating base layer,
   (b) showing the step of forming a conductive pattern on the insulating base layer,
   (c) showing the step of forming an insulating cover layer on the insulating base layer,
   (d) showing the step of inspecting a wired circuit board (in which a foreign substance is not present), and
   (d') showing the step of inspecting a wired circuit board (in which a foreign substance is present);

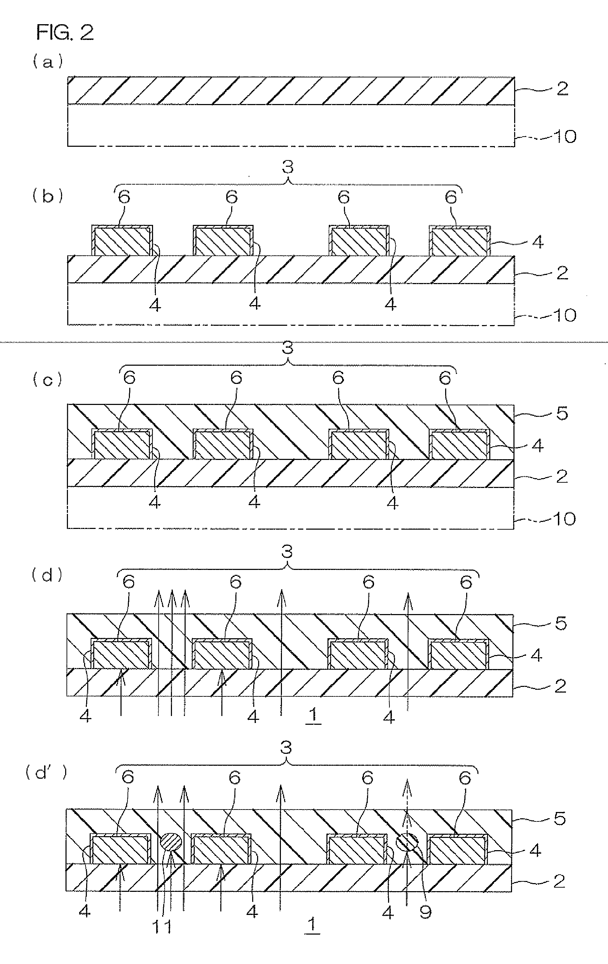

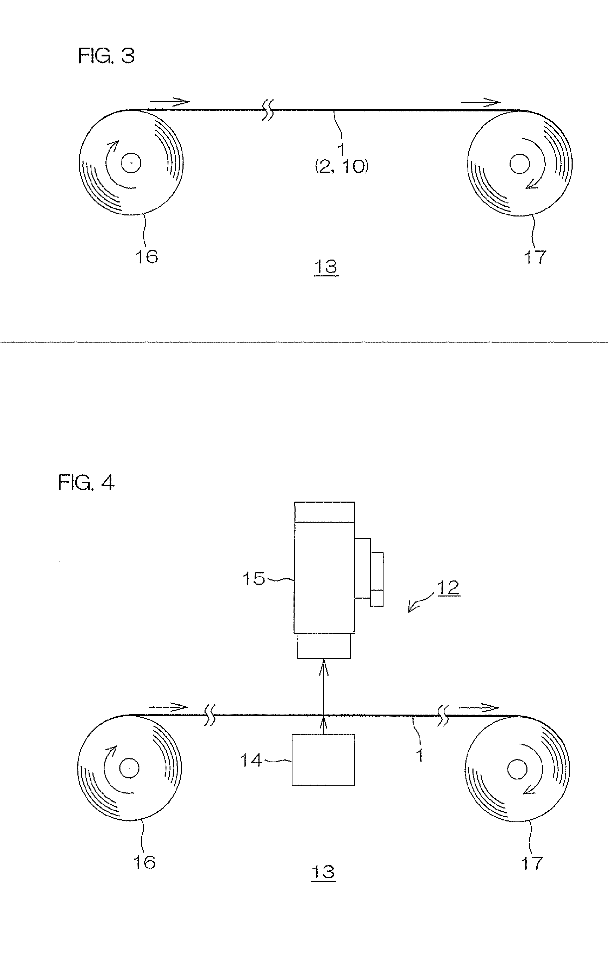

FIG. 3 is a schematic structural view of a production apparatus for implementing the embodiment of FIG. 2;
FIG. 4 is a schematic structural view of an inspection apparatus for performing an inspection process;

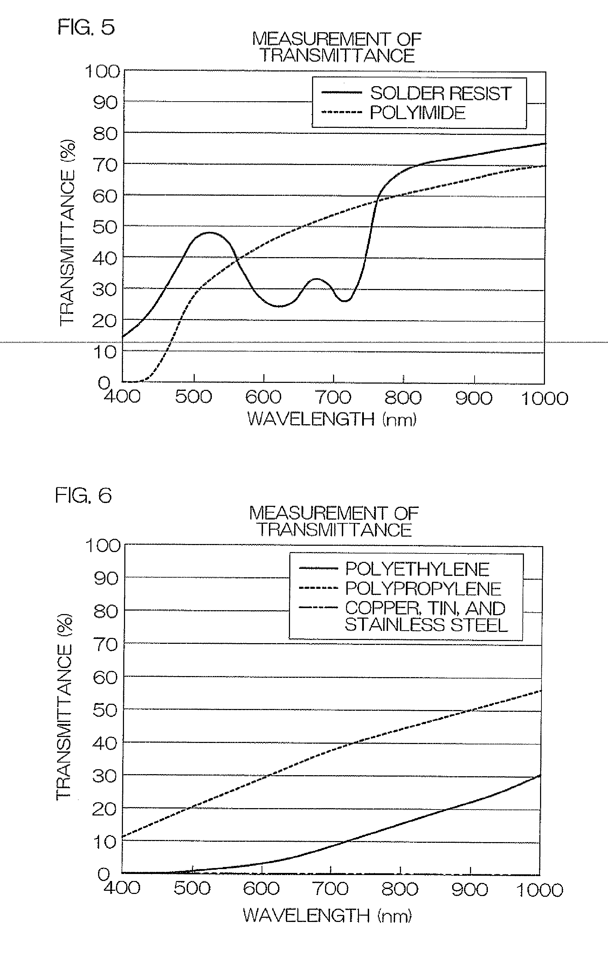

FIG. 5 is a graph showing the results of measuring the transmittances of a solder resist and polyimide;
FIG. 6 is a graph showing the results of measuring the transmittances of polyethylene, polypropylene, copper, tin, and stainless steel; and

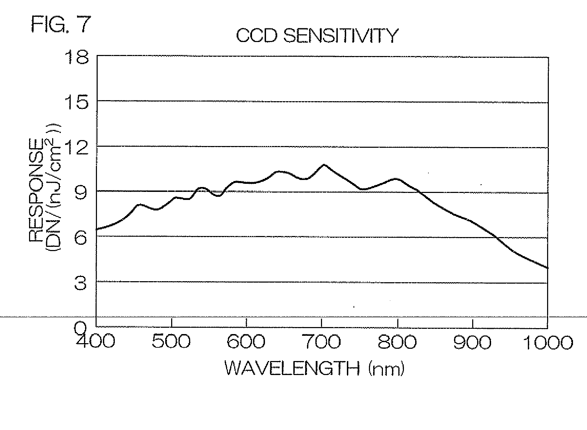

FIG. 7 is a graph showing the result of measuring the response of a CCD camera.

### DETAILED DESCRIPTION OF THE INVENTION

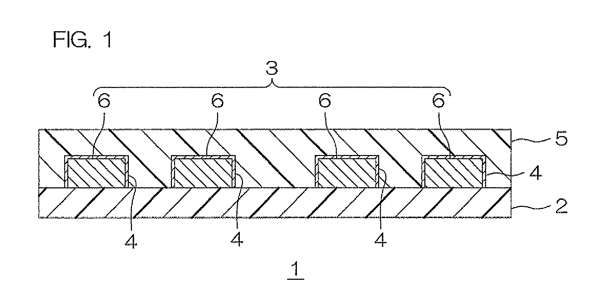

FIG. 1 is a cross-sectional view along a widthwise direction (perpendicular to a longitudinal direction) of an embodiment of a wired circuit board produced by a producing method of a wired circuit board of the present invention. FIG. 2 is a process view according to an embodiment of the producing method of a wired circuit board of the present invention. FIG. 3 is a schematic structural view of a production apparatus for implementing the embodiment of FIG. 2. FIG. 4 is a schematic structural view of an inspection apparatus for performing an inspection process described later.

In FIG. 1, a wired circuit board 1 is a flexible wired circuit board formed in a flat belt- or sheet-like shape extending in the longitudinal direction. The wired circuit board 1 includes an insulating base layer 2, a conductive pattern 3 formed on the insulating base layer 2, and an insulating cover layer 5 formed on the insulating base layer 2 so as to cover the conductive pattern 3.

Examples of an insulating material used to form the insulating base layer 2 include synthetic resins such as a polyimide resin, a polyamideimide resin, an acrylic resin, a polyether nitrile resin, a polyether sulfone resin, a polyethylene terephthalate (PET) resin, a polyethylene naphthalate resin, and a polyvinyl chloride resin. Preferably, a polyimide resin is used in terms of heat resistance, a light transmitting property, and the like.

The insulating base layer 2 is formed in a flat belt- or sheet-like shape in correspondence to the outer shape of the wired circuit board 1 extending in the longitudinal direction. The thickness of the insulating baser layer 2 is in a range of, e.g., 5 to 50 µm, or preferably 10 to 40 µm. When the thickness of the insulating base layer 2 is within the range shown above, the transmittance of the insulating cover layer 5 with respect to light with a specified wavelength can be set to a specified range.

The transmittance of the insulating base layer 2 with respect to light with a wavelength of more than 700 nm and less than 950 nm is in a range of, e.g., 45 to 100%, or preferably 60 to 100%. In particular, the transmittance of the insulating base layer 2 with respect to light with a wavelength of more than 750 nm and less than 900 nm is in a range of, e.g., 45 to 100%, or preferably 60 to 100%. The transmittance of the insulating base layer 2 with respect to light in a wavelength range of 825 nm to 875 nm is in a range of, e.g., 60 to 75%. When the transmittance to light at the specified wavelength mentioned above is within the range shown above, a foreign substance 11 can be stably inspected.

Examples of a conductive material used to form the conductive pattern 3 include copper, nickel, gold, a solder, and an alloy thereof. Preferably, copper is used in terms of electric resistance, a light transmitting property (light absorbing property), and the like.

The conductive pattern 3 integrally includes wires 6 which are disposed in parallel and mutually spaced-apart relation in the widthwise direction to extend along the longitudinal direction, and terminal portions not shown which are disposed at the both longitudinal end portions of the individual wires 6. The wires 6 are each covered with the insulating cover layer 5, while the terminal portions not shown are each exposed from the insulating cover layer 5. The conductive pattern 3 is formed in a generally rectangular shape when viewed in cross section (widthwise cross section).

The thickness of the conductive pattern 3 is in a range of, e.g., 3 to 30 µm, or preferably 5 to 20 µm. The width (widthwise length) of the wire 6, and the width of the terminal portion may be the same as or different from each other, and are in a range of, e.g., 5 to 500 µm, or preferably 15 to 200 µm. The spacing (spacing in the widthwise direction) between the wires 6, and the spacing between the terminal portions may be the same as or different from each other, and are in a range of, e.g., 5 to 200 µm, or preferably 5 to 100 µm.

The insulating cover layer 5 covers and electrically seals the wires 6. As an insulating material for forming the insulating cover layer 5, the same insulating material as used to form the insulating base layer 2 mentioned above, or an insulating material such as a solder resist is used. As the insulating material, a solder resist or polyimide is preferably used in terms of a light transmitting property. In the insulating material mentioned above, a pigment or the like is preferably mixed.

The pigment is mixed as necessary to facilitate the inspection of the foreign substance 11 described later. For example, an organic pigment is used. Examples of the organic pigment to be used include a green pigment, a blue pigment, a yellow pigment, and a red pigment. Preferably, a green pigment is used. As the green pigment, phthalocyanine green, iodine green, or the like is used. Examples of the green pigment include a pigment mixture of a blue pigment and a yellow pigment. For example, a pigment mixture of phthalocyanine blue and disazo yellow is used. These pigments can be used alone or in combination.

The ratio of the pigment contained in the insulating cover layer 5 is in a range of, e.g., 0.2 to 5 wt%, or preferably 0.5 to 1.5 wt%. When the mixture ratio of the pigment (e.g., a green pigment) is within the range shown above, the transmittance of the insulating cover layer 5 with respect to light with a wavelength of more than 700 nm and less than 950 nm, which is described later, can be set to a predetermined range.

The insulating cover layer 5 is formed on the surface of the insulating base layer 2 so as to cover the wires 6, and expose the terminal portions.

The thickness of the insulating cover layer 5 is in a range of, e.g., 10 to 50 µm, or preferably 14 to 20 µm.

When the thickness of the insulating cover layer 5 is within the range shown above, the transmittance of the insulating cover layer 5 with respect to light with a specified wavelength can be set to a specified range.

The transmittance of the insulating cover layer 5 with respect to light with a wavelength of more than 700 nm and less than 950 nm is in a range of, e.g., 30 to 100%, or preferably 65 to 100%. In particular, the transmittance of the insulating cover layer 5 with respect to light with a wavelength of more than 750 nm and less than 900 nm is in a range of, e.g., 45 to 100%, or preferably 65 to 100%. Further, the transmittance of the insulating cover layer 5 with respect to light in a wavelength range of 825 nm to 875 nm is in a range of, e.g., 70 to 75%. When the transmittance to light with the specified wavelength mentioned above is within the range shown above, the foreign substance 11 can be stably inspected.

Additionally, a metal thin film 4 is provided as necessary on the surface of the conductive pattern 3. In this case, i.e., the metal thin film 4 is interposed between the conductive pattern 3 and the insulating cover layer 5.
The metal thin film 4 is formed to expose the surfaces of the terminal portions not shown. Examples of a metal material for forming the metal thin film 4 include, e.g., tin, nickel, gold, chromium, titanium, zirconium, and an alloy thereof. Preferably, tin is used in terms of a light reflecting property. The thickness of the metal thin film 4 is in a range of, e.g., 0.2 to 5 µm, or preferably 0.5 to 2 µm.

Next, referring to FIGS. 2 to 4, a description is given to a producing method of the wired circuit board 1 as an embodiment of the producing method of a wired circuit board of the present invention.

In the method, as shown in FIG. 3, the wired circuit board 1 is formed in accordance with, e.g., a roll-to-roll method using a transport apparatus 13. The transport apparatus 13 includes, e.g., a feed-out roll 16, and a wind-up roll 17 which are disposed in mutually spaced-apart relation. The feed-out roll 16 and the wind-up roll 17 are each made of an insulating material such as, e.g., a resin material (such as, e.g., polyethylene (PE) or polypropylene (PP)).

In the roll-to-roll method, an elongated release sheet 10 (or the insulating base layer 2) wound up into a roll around the feed-out roll 16 is roll transported in each of the steps (FIGS. 2(a) to 2(d')) described later in such a manner that it is fed out toward the wind-up roll 17, and wound up by the wind-up roll 17. The individual steps shown in FIG. 2 are successively performed in the middle of the roll transport. The wound-up roll 17 that has wound up the release sheet 10 can be immediately used as the feed-out roll 16 in the subsequent step.

First, as shown in FIG. 2(a), the insulating base layer 2 is prepared in the method. The insulating base layer 2 is prepared by coating a varnish of a synthetic resin on the release sheet 10 indicated by the phantom line, drying the varnish, and then curing it as necessary. Alternatively, the insulating base layer 2 is prepared by coating a varnish of a photosensitive synthetic resin on the release sheet 10, drying the varnish, exposing it to light, processing it into the foregoing pattern by development, and then curing it as necessary. Otherwise, the insulating base layer 2 is prepared in advance as an elongated sheet made of a synthetic resin, as indicated by the solid line of FIG. 2(a), without using the release sheet 10.

The release sheet 10 is formed in a flat belt shape extending in the longitudinal direction. Examples of a material used to form the release sheet 10 include a metal material such as stainless steel, and a resin material such as PET. Preferably, stainless steel is used in terms of a reinforcing property. As an example of stainless steel, chromium stainless steel, nickel-chromium stainless steel, or the like can be listed. Specific examples of stainless steel used to form the release sheet 10 include SUS 301, SUS 304, SUS 305, SUS 309, SUS 310, SUS 316, SUS 317, SUS 321, and SUS 347 each based on the AISI (American Iron and Steel Institute) standard. The thickness of the release sheet 10 is in a range of, e.g., 3 to 100 µm, or preferably 5 to 30 µm.

Next, as shown in FIG. 2(b), the conductive pattern 3 is formed as a wired circuit pattern having the wires 6 and the terminal portions on the insulating base layer 2. The conductive pattern 3 is formed by a known patterning method such as, e.g., a subtractive method or an additive method.

Subsequently, the metal thin film 4 is formed on the conductive pattern 3 including the wires 6. The metal thin film 4 is laminated by plating such as, e.g., electroless plating.

Then, as shown in FIG. 2(c), the insulating cover layer 5 is formed in the foregoing pattern on the insulating base layer 2 so as to cover the metal thin film 4.

The insulating cover layer 5 is formed by a known method such as, e.g., the coating of a resin solution containing a pigment as necessary, or the sticking of a resin sheet containing a pigment as necessary.

In the coating of a resin solution, a resin solution (varnish) is prepared first by mixing a pigment in a solution of the synthetic resin mentioned above at an appropriate ratio.

Next, the vanish is coated on the insulating base layer 2 and the metal thin film 4 to form a cover coating. For the coating of the varnish, a coating method such as, e.g., screen printing, or casting is used. Thereafter, the formed cover coating is dried by heating at 100 to 180 °C for 30 to 120 minutes to form the cover coating.

It is also possible to cause the resin solution to further contain a photosensitive agent, and form the insulating cover layer 5 in the foregoing pattern by photoprocessing.

The insulating cover layer 5 can be formed by photoprocessing as follows. For example, a varnish containing a pigment and a photosensitive agent (a varnish of a photosensitive synthetic resin and a pigment) is coated on the entire surface of the insulating base layer 2 including the metal thin film 4, and dried to form a cover coating. Then, the cover coating is exposed to light via a photomask, processed into a pattern by development, and then cured as necessary to form the insulating cover layer 5.

In the sticking of the resin sheet, a sheet of an insulating material (containing a pigment as necessary) formed in advance into the foregoing pattern is laminated on the insulating base layer 2 and the metal thin film 4 via a known adhesive.

In this manner, the insulating cover layer 5 can be formed.

Thereafter, as shown in FIG. 2(d), the release sheet 10 is removed by, e.g., etching, stripping, or the like.

In this manner, the wired circuit board 1 (wired circuit board 1 prior to the inspection of the foreign substance 11) is formed.

Subsequently, as shown in FIGS. 2(d) and 2(d'), the foreign substance 11 in the wired circuit board 1 is inspected. Specifically, an inspection apparatus 12 shown in FIG. 4 is used in the inspection of the foreign substance 11.

The inspection apparatus 12 is disposed between the feed-out roll 16 and the wind-up roll 17, and includes a light emitting unit 14 and a light receiving unit 15. The light emitting unit 14 is disposed below and in spaced-apart and opposing relation to the wired circuit board 1, which is transported between the feed-out roll 16 and the wind-up roll 17, in the thickness direction of the wired circuit board 1. The light receiving unit 15 is disposed above and in opposing relation to the light emitting unit 14 in the thickness direction.

The light emitting unit 14 is disposed such that an upper surface thereof opposing the wired circuit board 1 serves as a light emitting surface from which light is emitted, and the light emitted from the light emitting surface is applied to the wired circuit board 1 for irradiation thereof.

Specifically, the light emitting unit 14 is a lamp capable of emitting light with a wavelength of more than 700 nm and less than 950 nm (preferably, light with a wavelength of more than 750 nm and less than 900 nm, or more preferably light in a wavelength range of 825 nm to 875 nm). Preferably, a near-infrared LED (Light Emitting Diode) capable of emitting light with the wavelength shown above is used as a light source.

The light receiving unit 15 is disposed above and in opposing relation to the wired circuit board 1 in the thickness direction, and disposed above the irradiated portion of the wired circuit board 1 (irradiation line along the widthwise direction of the wired circuit board 1) in the direction of transport. That is, the lower surface of the light receiving unit 15 serves as the light receiving surface at which the light is received, and the light receiving surface is disposed above and in opposing relation to the irradiated portion.

Specifically, the light receiving unit 15 is made of, e.g., a near-infrared ray camera, a CCD camera, or the like. Preferably, in terms of versatility, the light receiving unit 15 is made of a CCD camera, more specifically a CCD line scan camera capable of reading a line (irradiation line) perpendicular to the direction of transport in the wired circuit board 1.

In the inspection apparatus 12, the distance between the light emitting surface of the light emitting unit 14 and the irradiated portion (lower surface) of the wired circuit board 1 is set to a range of, e.g., 5 to 100 mm, or preferably 20 to 30 nm. On the other hand, the distance between the irradiated portion (upper surface) of the wired circuit board 1 and the light receiving surface of the light receiving unit 15 is set to a range of, e.g., 100 to 130 mm.

The foreign substance 11 in the wired circuit board 1 is inspected with the light emitting unit 14 and the light receiving unit 15, while the wired circuit board 1 wound around the feed-out roll 16 is fed out toward the wind-up roll 17.

That is, as shown in FIG. 2(d'), the foreign substance 11 is present in the insulating cover layer 5 of the wired circuit board 1 determined as a defective product. The material of the foreign substance 11 is, e.g., a material derived from the production of the wired circuit board 1, and also a conductive material which impairs the function of the insulating cover layer 5 (the function of sealing the wires 6). When the foreign substance 11 is contained, it is needed to reliably determine that the wired circuit board 1 is a defective product, and remove or mark (add a mark indicative of a defective product to) the wired circuit board 1. As the foregoing substance 11, the metal material forming the release sheet 10, the conductive material forming the conductive pattern 3, the metal material forming the metal thin film 4, or the like can be specifically listed. More specifically, a metal material such as copper, tin, or stainless steel can be listed. As the stainless steel, the same stainless steel as any of the variety of stainless steels used for the release sheet 10 mentioned above can be listed.

The inspection of the foreign substance 11 is typically performed simultaneously with or after the inspection of the conductive pattern 3.

In the inspection of the conductive pattern 3, light with the wavelength shown above is emitted from the light emitting unit 14 toward the insulating base layer 2 for irradiation thereof, as shown in FIGS. 2(d) and 4. Then, the light incident on the lower surface (back surface) of the insulating base layer 2, and successively transmitted through the insulating base layer 2 and the insulating cover layer 5, more specifically the light transmitted through the insulating cover layer 5 located around the wires 6, is sensed with the light receiving unit 15. In this manner, the pattern data of the conductive pattern 3 is obtained so that the pattern shape of the conductive pattern 3 is properly recognized, and a defect in the wires 6, a short circuit between the wires 6, or the like is accurately determined. The light incident on the lower surface of the insulating base layer 2, and transmitted through the insulating base layer 2, while being absorbed by the wires 6 (the lower surfaces of the wires 6, and the lower surface of the metal thin film 4), is cut off by the wires 6 to form a shadow, whereby the shadow is recognized (data is obtained) in the light receiving unit 15.

Specifically, in the inspection of the foreign substance 11 in the insulating cover layer 5, when the light (transmitted light forming an outer shape of the shadow) transmitted through the insulating cover layer 5 located around the foreign substance 11 is obtained as pattern data which is not present in the original pattern data of the conductive pattern 3 as shown in FIG. 2(d'), it is determined that the foreign substance 11 is present in the insulating cover layer 5. On the other hand, when there is no difference between the pattern data of the conductive pattern 3 obtained in the measurement and the original pattern data of the conductive pattern 3 as shown in FIG. 2(d), it is determined that the foreign substance 11 is not present in the insulating cover layer 5.

The inspection using the light with the wavelength shown above is typically performed at a room temperature (25 °C) so that the temperature of the surface (lower surface of the insulating base layer 2) of the wired circuit board 1 after the inspection is, e.g., a room temperature or not more than 30 °C, or preferably not more than 25 °C. That is, a temperature rise around the inspection of the foreign substance 11 is in a range of, e.g., not more than 5 °C.

The transport conditions for the transport apparatus 13 in the inspection of the foreign substance 11 are set such that the transport speed is in a range of, e.g., 5 to 50 mm/s, and preferably 20 to 25 mm/s.

Thereafter, the wired circuit board 1 determined as a defective product is removed by cutting it away from the elongated insulating base layer 2, or otherwise marked, while the wired circuit board 1 determined as a non-defective product can be produced.

In accordance with the producing method of the wired circuit board 1, light with a wavelength of more than 700 nm and less than 950 nm is applied to the insulating base layer 2 for irradiation thereof. When the foreign substance 11 is present in the insulating cover layer 5, the presence of the foreign substance 11 can be accurately inspected with the light transmitted through the insulating cover layer 5 located around the foreign substance 11. On the other hand, when the foreign substance 11 is not present in the insulating cover layer 5, the absence of the foreign substance 11 can be accurately inspected with the light transmitted through the insulating base layer 2, and further transmitted through the insulating cover layer 5.

In particular, since the wavelength of the light is more than 700 nm and less than 950 nm, even when the organic contaminant 9, i.e., a material (resin material (insulating material) such as a PE or PP) different in type from the material forming the insulating cover layer 5 is present in the insulating cover layer 5 in addition to the foreign substance 11, only the foreign substance 11 can be sensed without sensing the organic contaminant (such as PE or PP) 9 because the transmittance of PE or PP is sufficiently higher than that of the foreign substance 11. As a result, it is possible to prevent a reduction in the production efficiency of the wired circuit board 1.

At the same time, since the wavelength of light is more than 700 nm and less than 950 nm, excessive heating of the wired circuit board 1 can be prevented in the inspection of the foreign substance 11. This allows effective prevention of the thermal deformation of the wired circuit board 1, i.e., undulation or warping of the wired circuit board 1 resulting from the plastic deformation of the insulating base layer 2 and/or the insulating cover layer 5.

In addition, since the LED (near-infrared LED) can be used as the light source of the light emitting unit 14 of the inspection apparatus 12, it is possible to improve the directivity of light emitted for irradiation to achieve the stabilized irradiation intensity (illuminance) as well as the longer lifespan of the light source.

In the description given above, the foreign substance 11 is inspected by applying light from the insulating base layer 2 through the insulating cover layer 5 for irradiation thereof. However, the transmitted light used to inspect the foreign substance 11 is not limited thereto. For example, it is also possible to inspect the foreign substance 11 by switching the insulating layers in the irradiation process, i.e., by applying light from the insulating cover layer 5 through the insulating base layer 2, though not shown. More specifically, the light emitting unit 14 and the light receiving unit 15 in the inspection apparatus 12 are inverted each other in the thickness direction, or the insulating cover layer 5 is disposed as the lower layer, and the insulating base layer 2 is disposed as the upper layer in the wired circuit board 1 by switching the vertical positions of the feed-out roll 16 and the wind-up roll 17 in the transport apparatus 13.

The foregoing description has been given on the assumption that the foreign substance 11 present in the insulating cover layer 5 is sensed in the sensing of the foreign substance 11. However, the sensing of the foreign substance 11 is not limited thereto. For example, it is also possible to sense the foreign substance 11 present in the insulating base layer 2, though not shown. It is further possible to sense the foreign substance 11 present in both of the insulating cover layer 5 and the insulating base layer 2.

In the description given above, the roll-to-roll method is shown as an example of the producing method of a wired circuit board of the present invention. However, the producing method of a wired circuit board of the present invention is not limited thereto. For example, it is possible to perform each of the steps by a batch process using a single wafer method or the like, though not shown.

Moreover, in the description given above, the flexible wired circuit board in which the insulating base layer 2 is not supported is shown as an example of a wired circuit board obtained by the producing method of a wired circuit board of the present invention. However, the producing method of a wired circuit board of the present invention is also widely applicable to the production of various wired circuit boards such as, e.g., a flexible wired circuit board in which a metal supporting layer is provided as a reinforcing layer to support the lower surface of the insulating base layer 2, or a COF board (including a TAB tape carrier or the like).

### EXAMPLES

The present invention is described more specifically by showing the examples and the comparative examples hereinbelow. However, the present invention is by no means limited to the examples and the comparative examples.

### EXAMPLE 1

A flexible wired circuit board was produced by successively performing the following steps in accordance with the roll-to-roll method using the production apparatus shown in FIG. 3 described above.

That is, an elongated release sheet made of stainless steel (SUS 304) and having a width of 300 mm and a thickness of 25 µm was prepared. Then, a varnish of a photosensitive polyamic acid resin was coated on the release sheet, dried, exposed to light via a photomask, processed into the foregoing pattern by development, and then cured by heating to form an insulating base layer made of polyimide and having a thickness of 35 µm (see FIG. 2(a)).

Then, a conductive pattern having a thickness of 8 µm was formed in a wired circuit pattern having wires and terminal portions on the insulating base layer by an additive method. Subsequently, the metal thin film made of tin and having a thickness of 2 µm was formed on the surface of the conductive pattern by electroless tin plating (see FIG. 2(b)).

Then, a varnish of a solder resist (Product No. SN-9000-S commercially available from Hitachi Chemical Co., Ltd.) was coated on the metal thin film and the insulating base layer by screen printing, dried, exposed to light, processed into the foregoing pattern by development, and then cured by heating to form an insulating cover layer made of the solder resist and having a thickness of 18 µm (see FIG. 2(c)). The ratio of a pigment contained in the insulating cover layer was 0.8 wt%. In the formation of the insulating cover layer, during the coating of a solder resist solution, metal foreign substances and organic contaminants were caused to be contained in a part of the solder resist solution such that the metal foreign substances (ten pieces of copper, ten pieces of tin, and ten pieces of stainless steel) were mixed in 30 flexible wired circuit boards (in the insulating cover layers thereof) out of every three hundreds of flexible wired circuit boards to be produced, and the organic contaminants (ten pieces of PE, and ten pieces of PP) were further mixed in other twenty flexible wired circuit boards (in the insulating cover layers thereof).

Subsequently, as shown in FIG. 4 described above, the presence or absence of the metal foreign substances in the insulating cover layers was inspected using an inspection apparatus including a light emitting unit (Light Source: Near-Infrared LED Diffused Lighting), and a light receiving unit (CCD Line Scan Camera, Model No. P3-80-12K40 commercially available from DALSA, Inc.) (see FIGS. 2(d) and (d')). In the inspection apparatus, the distance between the light emitting surface of the light emitting unit and the irradiated portion (lower surface) of each of the flexible wired circuit boards was 30 mm, and the distance between the light receiving surface of the light receiving unit and the irradiated portion (upper surface) of the flexible wired circuit board was 120 nm. The inspection of the foreign substances was performed at a temperature of 25 °C using light with a wavelength of 800 nm. The speed of transport of the transport apparatus was 23.75 mm/second.

The results of determination in the inspection of the metal foreign substances are shown in Table 1.

### EXAMPLE 2

The metal foreign substances were inspected in the same manner as in EXAMPLE 1 except that the wavelength of light used for the inspection of the metal foreign substances was changed to 850 nm. The results of determination in the inspection of the metal foreign substances are shown in Table 1.

### EXAMPLE 3

The metal foreign substances were inspected in the same manner as in EXAMPLE 1 except that the wavelength of light used for the inspection of the metal foreign substances was changed to 875 nm. The results of determination in the inspection of the metal foreign substances are shown in Table 1. EXAMPLE 4

The metal foreign substances were inspected in the same manner as in EXAMPLE 1 except that the wavelength of light used for the inspection of the metal foreign substances was changed to 900 nm. The results of determination in the inspection of the metal foreign substances are shown in Table 1. EXAMPLE 5

The metal foreign substances were inspected in the same manner as in EXAMPLE 1 except that the wavelength of light used for the inspection of the metal foreign substances was changed to 750 nm. The results of determination in the inspection of the metal foreign substance s are shown in Table 1.

### COMPARATIVE EXAMPLE 1

The metal foreign substances were inspected in the same manner as in EXAMPLE 1 except that the wavelength of light used for the inspection of the metal foreign substances was changed to 950 nm. The results of determination in the inspection of the metal foreign substances are shown in Table 1.

### COMPARATIVE EXAMPLE 2

The metal foreign substances were inspected in the same manner as in EXAMPLE 1 except that the wavelength of light used for the inspection of the metal foreign substances was changed to 1000 nm. The results of determination in the inspection of the metal foreign substances are shown in Table 1.

### COMPARATIVE EXAMPLE 3

The metal foreign substances were inspected in the same manner as in EXAMPLE 1 except that the wavelength of light used for the inspection of the metal foreign substances was changed to 2500 nm. The results of determination in the inspection of the metal foreign substances are shown in Table 1.

### COMPARATIVE EXAMPLE 4

The metal foreign substances were inspected in the same manner as in EXAMPLE 1 except that the wavelength of light used for the inspection of the metal foreign substances was changed to 700 nm. The results of determination in the inspection of the metal foreign substances are shown in Table 1.

**Table 1**

| Examples/ Comparative Examples | Wave-Le ngth (nm) | Inspection of Metal foreign substances | | | Inspection of Organic contaminants | | Temperature of Back Surface Immediately After Inspection (°C) | Deformation Inspection | Comprehensive Evaluation |
|---|---|---|---|---|---|---|---|---|---|
| | | Copper | Tin | Stainless Steel | Polyethylene | Polypropylene | | | |
| Example 1 | 800 | Excellent | Excellent | Excellent | Excellent | Excellent | 25 | Excellent | Excellent |
| Example 2 | 850 | Excellent | Excellent | Excellent | Good | Excellent | 25 | Excellent | Good |
| Example 3 | 875 | Excellent | Excellent | Excellent | Good | Excellent | 25 | Excellent | Good |
| Example 4 | 900 | Excellent | Excellent | Excellent | Fair | Good | 25 | Excellent | Fair |
| Example 5 | 750 | Excellent | Excellent | Excellent | Fair | Good | 25 | Excellent | Fair |
| Comparative Examples 1 | 950 | Excellent | Excellent | Excellent | Poor | Poor | 25 | Excellent | Poor |
| Comparative Example 2 | 1000 | Excellent | Excellent | Excellent | Poor | Poor | 30 | Good | Poor |
| Comparative Example 3 | 2500 | Un-inspectable | Un-inspeictable | Un-inspectable | Un-inspectable | Un-inspectable | 85 | Poor | Poor |
| Comparative Example 4 | 700 | Excellent | Excellent | Excellent | Poor | Poor | 25 | Excellent | Poor |

The following is the description of the terms used in the columns of Table 1 showing the results of inspecting the individual metal foreign substances.

### (Inspection of Metal foreign substances)

"Excellent" indicates the case where it was determined that the number of defective products in which the metal foreign substance of each of the metals was present was ten out of three hundreds of the flexible wired circuit board.

"Good" indicates the case where it was determined that the number of defective products in which the metal foreign substance of each of the metals was present was eight or nine out of three hundreds of the flexible wired circuit boards.

"Fair" indicates the case where it was determined that the number of defective products in which the foreign substance of each of the metals was present was four to seven out of three hundreds of the flexible wired circuit boards.

"Poor" indicates the case where it was determined that the number of defective products in which the foreign substance of each of the metals was present was zero to three out of three hundreds of the flexible wired circuit boards.

The following is the description of the terms used in the columns of Table 1 showing the results of inspecting the individual organic contaminants.

### (Inspection of Organic Contaminants)

"Excellent" indicates the case where it was determined that the number of non-defective products in which the organic contaminant of each of the organic materials was present was ten out of three hundreds of the flexible wired circuit boards.

"Good" indicates the case where it was determined that the number of non-defective products in which the organic contaminant of each of the organic materials was present was eight or nine out of three hundreds of the flexible wired circuit boards.

"Fair" indicates the case where it was determined that the number of non-defective products in which the organic contaminant of each of the organic materials was present was four to seven out of three hundreds of the flexible wired circuit boards.

"Poor" indicates the case where it was determined that the number of non-defective products in which the organic contaminant of each of the organic materials was present was zero to three out of three hundreds of the flexible wired circuit boards.

In the inspection of the metal foreign substances (or organic contaminants) mentioned above, "Uninspectable" indicates the case where the flexible wired circuit board could not be inspected due to the significant deformation thereof.

### (Evaluation)

### (1) Measurement of Transmittances

On a PET plate having a thickness of 25 µm, a film made of a solder resist and having a thickness of 10 µm was formed from a varnish of the solder resist in the same manner as in EXAMPLE 1. In addition, a sheet made of polyimide and having a thickness of 25 µm, a sheet made of polyethylene and having a thickness of 1000 µm, and a sheet made of polypropylene and having a thickness of 1000 µm were individually prepared. Further, a copper foil having a thickness of 80 µm, a tin foil having a thickness of 200 µm, and a stainless steel (SUS 304) foil having a thickness of 10 µm were also individually prepared.

The transmittances of the solder resist, polyimide, polyethylene, polypropylene, copper, tin, and stainless steel were individually measured using a transmittance measurement device (UV/VIS/NIR Spectrophotometer V-670™ commercially available from JASCO Corporatian).

The results of measuring the transmittances of the solder resist and polyimide are shown in FIG. 5. The results of measuring the transmittances of polyethylene, polypropylene, copper, tin, and stainless steel are shown in FIG. 6.

### (2) Measurement of Response of CCD Camera

The response (sensitivity) of the CCD line scan camera was measured by applying light in a wavelength range of 400 to 1000 nm to the light receiving surface of the CCD line scan camera for irradiation thereof. The result of the measurement is shown in FIG. 7.

### (3) Measurement of Temperature.

In each of EXAMPLES and COMPARATIVE EXAMPLES, the temperature of the lower surface (back surface) of the insulating base layer immediately after the inspection of the metal foreign substances was measured using a thermocouple thermometer. The result of the measurement is shown in Table 1.

### (4) Deformation Inspection

The deformed state of the flexible wired circuit board produced in each of EXAMPLES and COMPARATIVE EXAMPLES was visually observed. The result of the observation is shown in Table 1.

The following is the description of the terms used in the columns of Table 1 each showing the result of the deformation inspection.

"Excellent" indicates the case where neither undulation nor warping was recognized.

"Good" indicates the case where undulation and warping were scarcely recognized.

"Fair" indicates the case where slight undulation or warping was recognized.

"Poor" indicates the case where significant undulation or warping was recognized.

### (Considerations)

### (1) Transmittances

As can be seen from FIGS. 5 and 6, when light with a wavelength of more than 700 nm and less than 950 nm is used in the inspection of metal foreign substances, constant (in a range of more than about 25%) transmittances can be obtained for polyimide as an insulating material for forming an insulating cover layer and the solder resist. Therefore, it is understood that the foreign substances can be reliably inspected by applying such light from the insulating base layer through the insulating cover layer. It is also understood that, when the wavelength is not more than 700 nm, the metal foreign substances cannot be inspected because the transmittances of the insulating materials mentioned above are excessively low, or the transmittances are extremely unstable with respect to a wavelength change in the range.

In addition, the transmittances of the organic contaminants made of polyimide, PE, PP, and the like are as high as about 5% or more compared with the transmittances of the metal foreign substances which are substantially zero (0) %. Accordingly, even when such organic contaminants are present, it is possible to prevent the organic contaminants from being erroneously sensed (erroneous sensing) as the metal foreign substances. As a result, it is understood that a reduction in production efficiency based on the erroneous sensing of the organic contaminants can be prevented.

Further, as can be seen from FIG. 5, the transmittances of polyimide and the solder resist are more stable with respect to a wavelength change in the wavelength range of more than 750 nm and less than 900 nm. Therefore, it is understood that the foreign substances can be more reliably inspected.

### (2) Sensitivity of CCD Camera

As can be seen from FIG. 7, when the CCD line scan camera is used as the light receiving unit of the inspection apparatus, constantly high (not less than 5 DN/(nJ/cm²)) response can be obtained. Therefore, it is understood that the foreign substances can be reliably inspected by applying light from the insulating base layer through the insulating cover layer.

## Claims

1. A producing method of a wired circuit board, comprising the steps of:
preparing an insulating base layer;
forming a wire on the insulating base layer;
forming an insulating cover layer on the insulating base layer so as to cover the wire; and
applying near-infrared light with a wavelength of more than 700 nm and less than 950 nm from either one of the insulating base layer and the insulating cover layer through the other insulating layer to thereby inspect a foreign substance with the light transmitted there through.

2. The producing method of a wired circuit board according to Claim 1, wherein the wavelength of the near-infrared light is more than 750 nm and less than 900 nm.

3. The producing method of a wired circuit board according to Claim 1, wherein the foreign substance is made of at least one metal material selected from the group consisting of copper, tin, and stainless steel.
